# EUROPEAN PATENT APPLICATION

(11) **EP 4 769 022 A1**
(43) Date of publication of application: **01.07.2026**
(21) Application number: 25861692.9
(22) Date of filing: 13.01.2025
(51) Int. Cl.: G03F 7/004, G03F 7/00, C08F 283/04

(54) **PHOTOSENSITIVE POLYIMIDE COMPOSITION, MANUFACTURING METHOD FOR PATTERNS, STRUCTURE, COMPONENT, AND DEVICE**

(30) Priority: 15.10.2024 CN 202411439374
(71) Applicant: Jiangsu Aisen Semiconductor Material Co., Ltd., Suzhou, Jiangsu 215341 (CN); Aisen Semiconductor Materials (Nantong) Co., Ltd., Nantong, Jiangsu 226010 (CN)
(72) Inventor: LIU, Bin, Suzhou, Jiangsu 215341 (CN); ZHANG, Bing, Suzhou, Jiangsu 215341 (CN); XIANG, Wensheng, Suzhou, Jiangsu 215341 (CN); ZHAO, Jianlong, Suzhou, Jiangsu 215341 (CN); HU, Zeming, Suzhou, Jiangsu 215341 (CN); HONG, Yongbo, Suzhou, Jiangsu 215341 (CN); LIU, Zhuang, Suzhou, Jiangsu 215341 (CN)
(74) Representative: J A Kemp LLP
(86) International application number: PCT/CN2025/072038
(87) International publication number: WO 2026/081375

(57) **Abstract**

Provided are a photosensitive polyimide composition, a method for manufacturing a pattern, a structure, a component, and an apparatus. The composition includes the following raw materials in parts by weight: 100 parts of a block polymer soluble in an alkaline aqueous solution; 5-30 parts of a thermal cross-linker selected from an epoxy-containing cross-linker or a -CH₂OR-containing cross-linker; 0.5-5 parts of a photoacid generator; and 0.5-10 parts of a silane coupling agent. The photosensitive polyimide composition has good alkali solubility, can reproduce a fine pattern, and has low warpage stress and high chemical stability and adhesiveness after low-temperature curing.

## Description

### TECHNICAL FIELD

The present application belongs to the technical field of new materials and, in particular, relates to a photosensitive polyimide composition, a method for manufacturing a pattern, a structure, a component, and an apparatus.

### BACKGROUND

With a gradual increase in the semiconductor packaging density, photosensitive polyimide (PSPI) materials have gradually evolved towards low-temperature curing, high sensitivity, high resolution, and low warpage stress.

WO2018225676A1 discloses a method of reducing the glass transition temperature of a polyimide (PI) polymer in conjunction with a thermal base generator. This method enables low-temperature curing at 200-230°C and yields a negative PSPI cured product with excellent adhesion. However, this method fails to satisfy the requirements for high sensitivity, high resolution, and low warpage stress.

CN102575139A discloses a method using a chemically imidized PI polymer containing a phenolic hydroxyl or carboxyl group, in conjunction with a suitable cross-linker. This method enables low-temperature curing at 200-230°C and yields a positive PSPI cured product with excellent chemical resistance. However, an improvement in the chemical resistance is quite limited, and such compositions mostly have a relatively low sensitivity.

WO2008026406A1 discloses a method using a polymer containing a phenolic hydroxyl group, such as poly(p-hydroxystyrene) or a phenolic resin, in conjunction with a cross-linker and toughening with rubber particles. This method enables low-temperature curing at 200°C and yields a composition with a relatively high sensitivity, a relatively high resolution, and low warpage stress. However, the cured product obtained by this method exhibits relatively poor mechanical performance and a limited improvement in toughness, which may lead to abnormal reliability.

Information disclosed in the background is intended only to enhance the understanding of the general background of the present application and is not to be regarded as admitting or implying in any manner that the information constitutes the existing art known to those of ordinary skill in the art.

### SUMMARY

The present application provides a photosensitive polyimide composition, a method for manufacturing a pattern, a structure, a component, and an apparatus, where the photosensitive polyimide composition has excellent alkali solubility, can reproduce a fine pattern, and has low warpage stress and high chemical stability and adhesiveness after low-temperature curing.

In a first aspect, an embodiment of the present application provides a photosensitive polyimide composition including the following raw materials in parts by weight:
100 parts of a block polymer, which is soluble in an alkaline aqueous solution and has a structural formula of 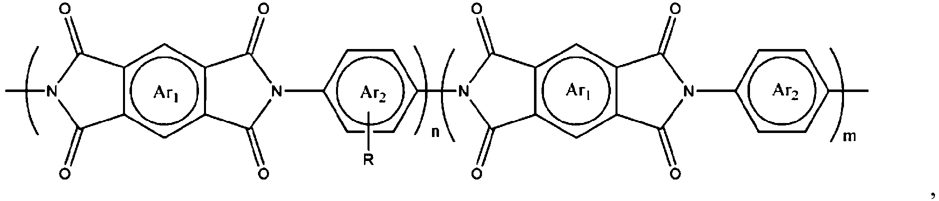 where R is 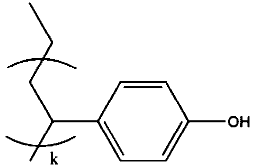 Ar₁ is selected from a tetra-substituted organic group and Ar₂ is selected from a di-substituted organic group; m + n = 5-200, n/(m + n) = 0.05-1, and k = 2-10;
5-30 parts of a thermal cross-linker, which is selected from an epoxy-containing cross-linker or a -CH₂OR-containing cross-linker;
0.5-5 parts of a photoacid generator, which has a structural formula of 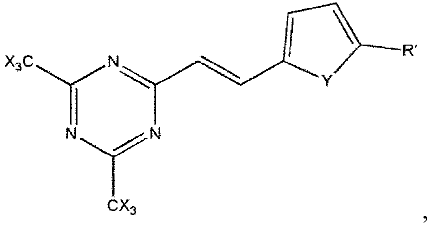 where R' is selected from hydrogen, alkyl having 1 to 4 carbon atoms, or alkoxy having 1 to 4 carbon atoms, X is selected from halogen, and Y is oxygen or sulfur; and
0.5-10 parts of a silane coupling agent.

In one or more embodiments of the present application, Ar₁ is the tetra-substituted organic group selected from the following: 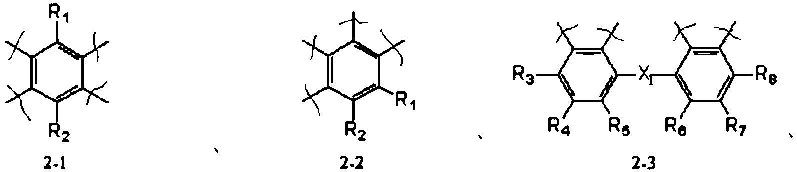 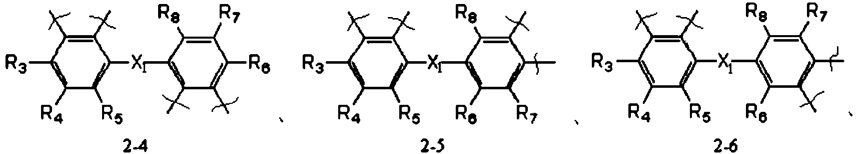 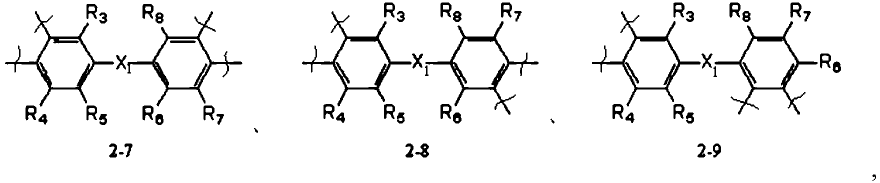 where R₁ to R₈ are mono-substituted organic groups, and X₁ is a di-substituted group.

In one or more embodiments of the present application, R₁ to R₈ are the mono-substituted organic groups each independently selected from hydrogen, halogen, C1 to C5 substituted alkyl (where the substitution here refers to mono-substitution or multiple substitutions with other non-alkyl groups, so does the following substitution), or C1 to C5 unsubstituted alkyl.

In one or more embodiments of the present application, R₁ to R₈ are the mono-substituted organic groups each selected from hydrogen, fluorine, methyl, or trifluoromethyl.

In one or more embodiments of the present application, X₁ is the di-substituted group selected from oxygen, C1 to C5 substituted or unsubstituted alkylene, sulfur, sulfonyl, or carbonyl.

In one or more embodiments of the present application, X₁ is the di-substituted group selected from oxygen, methylene, sulfur, sulfonyl, carbonyl, -C(CH₃)₂-, or -C(CF₃)₂-.

In one or more embodiments of the present application, Ar₂ is the di-substituted organic group selected from the following: 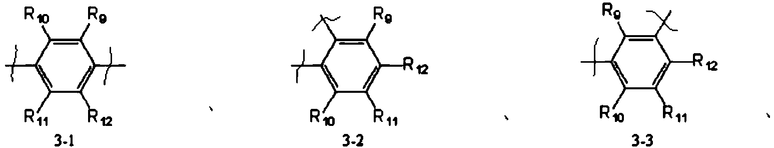 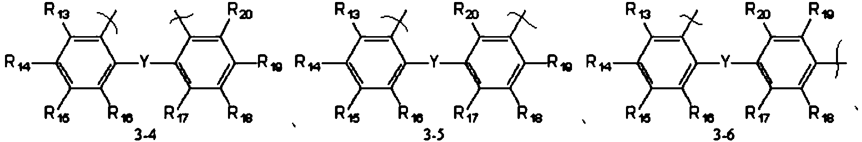 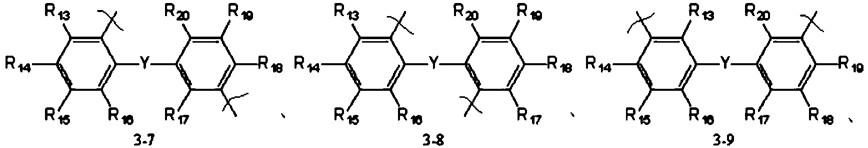 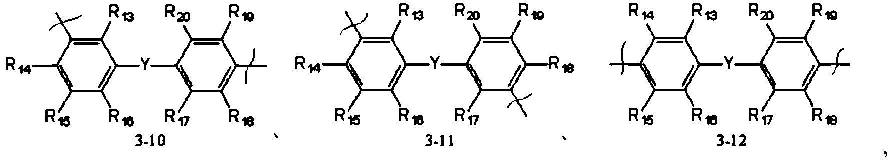 where R₉ to R₂₀ are mono-substituted organic groups, and Y is a di-substituted group.

In one or more embodiments of the present application, R₉ to R₂₀ are the mono-substituted groups each independently selected from hydrogen, halogen, C1 to C5 substituted alkyl, or C1 to C5 unsubstituted alkyl.

In one or more embodiments of the present application, R₉ to R₂₀ are the mono-substituted groups each independently selected from hydrogen, fluorine, methyl, or trifluoromethyl.

In one or more embodiments of the present application, Y is the di-substituted group selected from oxygen, C1 to C5 substituted alkylene, C1 to C5 unsubstituted alkylene, sulfur, sulfonyl, or carbonyl.

In one or more embodiments of the present application, Y is the di-substituted group selected from oxygen, methylene, sulfur, sulfonyl, carbonyl, -C(CH₃)₂-, or -C(CF₃)₂-.

In one or more embodiments of the present application, the thermal cross-linker is selected from a compound represented by any one of the following formulas: 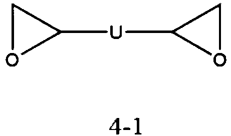 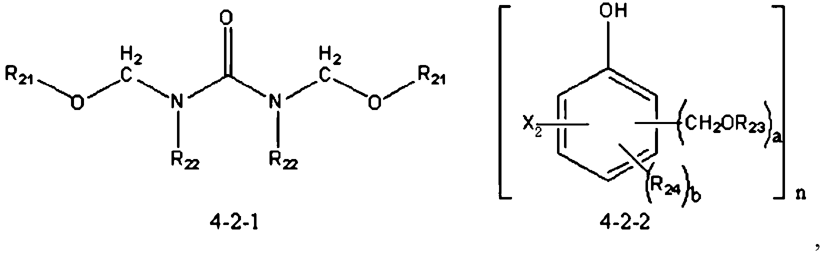 where U is selected from a di-substituted organic group containing an alicyclic ring or an aromatic ring, R₂₁ is independently selected from hydrogen or a mono-substituted organic group, R₂₂ is selected from hydrogen, a mono-substituted organic group, or a ring structure having a substituent, R₂₃ is selected from hydrogen or a mono-substituted organic group, R₂₄ is selected from a mono-substituted organic group, n is an integer from 1 to 4, X₂ is selected from a mono-substituted organic group, a di-substituted organic group, a tri-substituted organic group, or a tetra-substituted organic group, a is an integer from 1 to 4, and b is an integer from 0 to 3. Preferably, when a is 2, 3, or 4, R₂₃ is the same or different, and when b is 2 or 3, R₂₄ is the same or different.

In one or more embodiments of the present application, 100-200 parts of a solvent and/or 100-1000 ppm of a leveling agent are further included.

In a second aspect, an embodiment of the present application provides a method for manufacturing a pattern. The method for manufacturing a pattern includes coating the photosensitive polyimide composition according to the first aspect on a support substrate, followed by drying, exposure, development, and heating, to obtain the pattern.

In one or more embodiments of the present application, a light source for the exposure is an i-ray (an i-line light source).

In a third aspect, an embodiment of the present application provides a photocured structure obtained by the method for manufacturing a pattern according to the second aspect. The pattern here includes a planar structure (such as a surface protective film or an interlayer insulating film) or a graphic structure (such as an imprint structure or a pattern).

In a fourth aspect, an embodiment of the present application provides an electronic component. The electronic component includes a body and the photocured structure according to the third aspect, the photocured structure being formed on the body.

In a fifth aspect, an embodiment of the present application provides an apparatus. The apparatus includes a body and the electronic component according to the fourth aspect, the electronic component being disposed to the body.

Compared with the existing art, the present application provides the photosensitive polyimide composition, the method for manufacturing a pattern, the structure, the component, and the apparatus so that a portion exposed to ultraviolet light is easily soluble in the alkaline aqueous solution and a portion not exposed to ultraviolet light is insoluble in the alkaline aqueous solution, and thus the fine pattern can be effectively reproduced. Moreover, the photosensitive polyimide composition has excellent alkali solubility and a high resolution, and low warpage stress, high adhesiveness, and good chemical resistance after low-temperature curing (180-200°C).

### BRIEF DESCRIPTION OF DRAWINGS

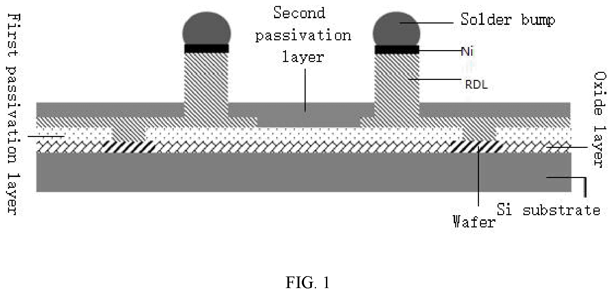

FIG. 1 is a schematic diagram of a semiconductor packaging structure implemented according to an embodiment of the present application.

### DETAILED DESCRIPTION

Embodiments of the present application are described in detail below, but it is to be understood that the embodiments are not intended to limit the scope of the present application.

Unless otherwise expressly indicated, the term "comprising" or a variation thereof, such as "including" or "containing" throughout the description and claims is to be understood as including the recited elements or components without excluding other elements or components.

An embodiment of the present application provides a photosensitive polyimide composition including the following components:
(a) a block polymer soluble in an alkaline aqueous solution; (b) a thermal cross-linker; (c) a photoacid generator; and (d) a silane coupling agent.

The photosensitive polyimide composition can effectively reproduce a fine pattern because a portion exposed to ultraviolet light is insoluble in the alkaline aqueous solution and a portion not exposed to ultraviolet light is soluble in the alkaline aqueous solution. The photosensitive polyimide composition of the present application promotes a reaction between the cross-linker and a resin through acid generation, increases the dissolution rate ratio (dissolution contrast) of an exposed portion of the pattern and an unexposed portion of the pattern relative to an alkaline developer, and thus has excellent sensitivity and resolution. Meanwhile, the photosensitive polyimide composition has low warpage stress, excellent chemical resistance and adhesiveness after high-temperature curing.

Firstly, a criterion for the solubility of the component (a) in the alkaline aqueous solution is described below. The component (a) is dissolved alone or together with other components in any solvent to obtain a photosensitive composition, the obtained photosensitive composition is spin-coated on a substrate such as a silicon wafer to form a coating having a thickness of about 5 µm, and the coating is immersed in an aqueous solution of tetramethylammonium hydroxide at 20-25°C. If the coating can be dissolved to form a uniform solution, the used component (a) is considered as soluble in the alkaline aqueous solution.

The alkaline aqueous solution refers to an aqueous solution of tetramethylammonium hydroxide, an aqueous solution of a metal hydroxide, an aqueous solution of an organic amine, or the like.

Considering the processability and thermal resistance of a graft polymer soluble in the alkaline aqueous solution, which is used as the component (a), a main chain backbone is preferably a polyimide-based polymer, and a graft chain backbone is preferably a poly(p-hydroxystyrene)-based polymer.

Further, the component (a) is more preferably a polyimide-poly(p-hydroxystyrene) graft copolymer, which is a polymer having a structural unit represented by Formula 1: 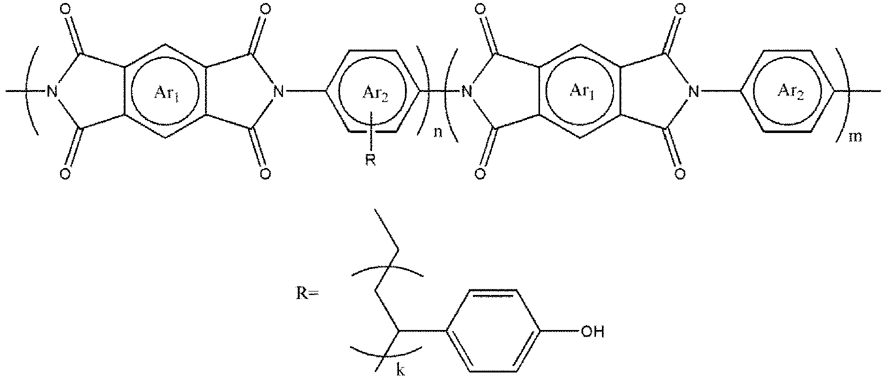 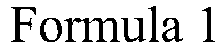 where Ar₁ is selected from a tetra-substituted organic group and Ar₂ is selected from a di-substituted organic group; m + n = 5-200, for example, 5, 10, 15, 20, 25, 35, 40, 50, 70, 75, 80, 85, 95, 100, 110, 120, 135, 150, 160, 175, 180, 185, 190, 195, 200, and any value between 5 and 200; and n/(m + n) = 0.05-1, for example, 0.05, 0.1, 0.15, 0.2, 0.25, 0.3, 0.35, 0.4, 0.5, 0.6, 0.7, 0.8, 0.9, 1, and any value between 0.05 and 1.

Further, Ar₁ is, at each occurrence identically or differently, selected from any one of tetra-substituted organic groups represented by Formula 2: 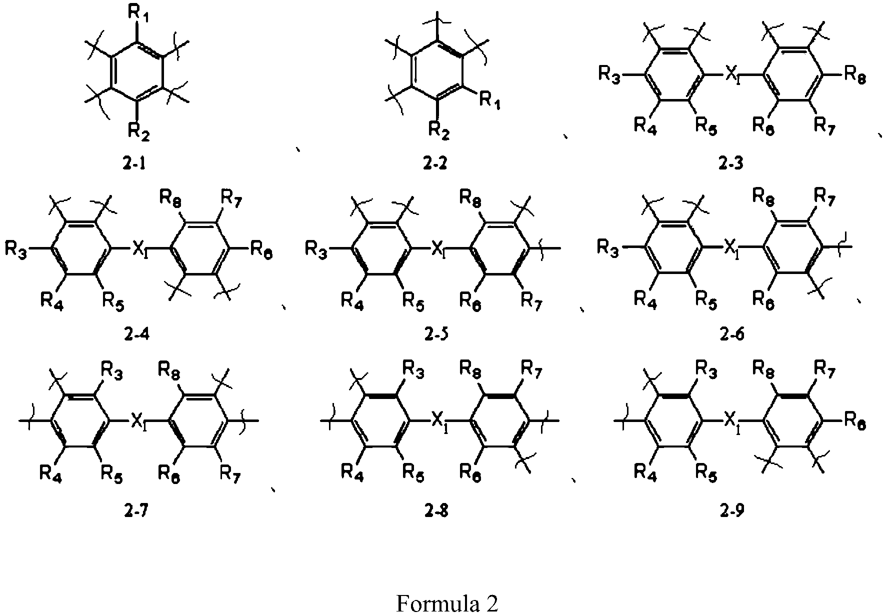 where R₁ to R₈ are mono-substituted organic groups, and X₁ is a di-substituted group.

Specifically, R₁ to R₈ are each independently selected from any one of hydrogen, halogen, or C1 to C5 substituted or unsubstituted alkyl; preferably, R₁ to R₈ are each independently selected from any one of hydrogen, fluorine, methyl, or trifluoromethyl.

X₁ is selected from any one of oxygen, C1 to C5 substituted or unsubstituted alkylene, sulfur, sulfonyl, or carbonyl; X₁ is selected from any one of oxygen, methylene, sulfur, sulfonyl, carbonyl, -C(CH₃)₂-, or -C(CF₃)₂-.

Specifically, in Formula 1, Ar₁ is the tetra-substituted organic group, generally a residue derived from a tetracarboxylic dianhydride or a derivative thereof that forms an amide-ester structure with a diamine. Preferably, Ar₁ is a tetra-substituted aromatic group and preferably a residue of a tetracarboxylic dianhydride or a derivative thereof having a structure in which four binding sites are present on an aromatic ring. The tetracarboxylic dianhydride may be, for example, pyromellitic dianhydride, 3,3',4,4'-biphenyltetracarboxylic dianhydride, 2,3,3',4'-biphenyltetracarboxylic dianhydride, 2,2',3,3'-biphenyltetracarboxylic dianhydride, 3,3',4,4'-benzophenonetetracarboxylic dianhydride, 2,2',3,3'-benzophenonetetracarboxylic dianhydride, 2,2-bis(3,4-dicarboxyphenyl)propane dianhydride, 2,2-bis(2,3-dicarboxyphenyl)propane dianhydride, 1,1-bis(3,4-dicarboxyphenyl)ethane dianhydride, 1,1-bis(2,3-dicarboxyphenyl)ethane dianhydride, bis(3,4-dicarboxyphenyl)methane dianhydride, bis(2,3-dicarboxyphenyl)methane dianhydride, bis(3,4-dicarboxyphenyl)sulfone dianhydride, bis(3,4-dicarboxyphenyl)ether dianhydride, 1,2,5,6-naphthalenetetracarboxylic dianhydride, 9,9-bis(3,4-dicarboxyphenyl)fluorene dianhydride, 9,9-bis{4-(3,4-dicarboxyphenoxy)phenyl}fluorene dianhydride, 2,3,6,7-naphthalenetetracarboxylic dianhydride, 2,3,5,6-pyridinetetracarboxylic dianhydride, 3,4,9,10-perylenetetracarboxylic dianhydride, 2,2-bis(3,4-dicarboxyphenyl)hexafluoropropane dianhydride, or another aromatic tetracarboxylic dianhydride, butanetetracarboxylic dianhydride, 1,2,3,4-cyclopentanetetracarboxylic dianhydride, or another aliphatic tetracarboxylic dianhydride. These tetracarboxylic dianhydrides may be used alone, or a combination of two or more tetracarboxylic dianhydrides may be used.

Further, Ar₂ is, at each occurrence identically or differently, selected from any one of di-substituted organic groups represented by Formula 3-1 to Formula 3-12: 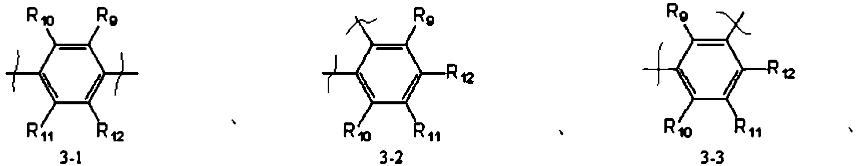 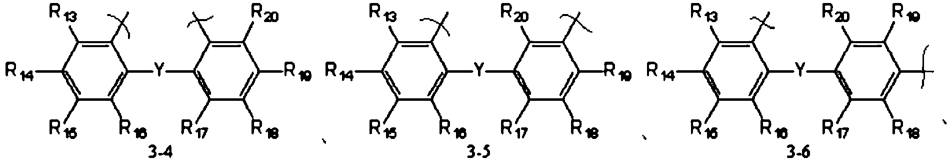 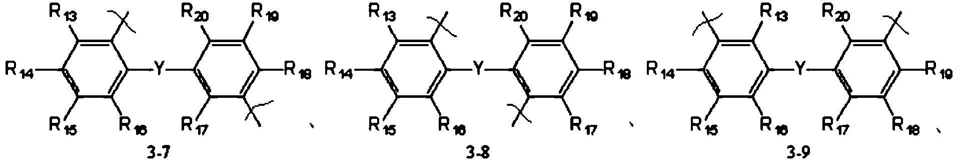 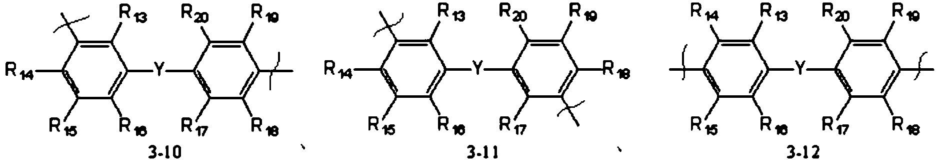 where R₉ to R₂₀ are mono-substituted organic groups, and Y is a di-substituted group.

Specifically, R₉ to R₂₀ are each independently selected from any one of hydrogen, halogen, or C1 to C5 substituted or unsubstituted alkyl; preferably, R₉ to R₂₀ are each independently selected from any one of hydrogen, fluorine, methyl, or trifluoromethyl.

Y is selected from any one of oxygen, C1 to C5 substituted or unsubstituted alkylene, sulfur, sulfonyl, or carbonyl providing two substitution positions; more preferably, Y is selected from any one of oxygen, methylene, sulfanyl, sulfonyl, carbonyl, -C(CH₃)₂-, or -C(CF₃)₂-providing two substitution positions.

Further, in Formula 1, Ar₂ is the di-substituted organic group, generally a residue derived from an amino acid that forms an amide structure with a diamine. Preferably, Ar₂ is a di-substituted aromatic group and preferably a residue of an amino acid having a structure in which two binding sites are present on an aromatic ring. The amino acid may be, for example, para-aminobenzoic acid, meta-aminobenzoic acid, or ortho-aminobenzoic acid. The amino acids may be used alone, or a combination of two or more amino acids may be used.

Additionally, to improve adhesion to a substrate without destroying the thermal resistance, a certain proportion of an aliphatic group with a siloxane structure may be copolymerized in Ar₂, where the aliphatic group is preferably 1-10 mol% of bis(3-aminopropyl)tetramethyldisiloxane or bis(p-aminophenyl)octamethylpentasiloxane.

A terminal group of aromatic polyamide represented by Formula 1 becomes carboxylic acid or an amine depending on the feed ratio of Ar₁ and Ar₂. One capping agent or two capping agents may be selected as required to react with a terminal of the polymer so that one terminal or two terminals are each a saturated aliphatic group, an unsaturated aliphatic group, a carboxyl group, a phenolic hydroxyl group, a sulfonic acid group, or a sulfanyl group. The capping rate is preferably 30% to 100%.

The following are to be noted: (1) halogen mentioned in R₁ to R₂₀ is not limited to fluorine and may be bromine, chlorine, or the like;
(2) C1 to C5 substituted or unsubstituted alkyl mentioned in R₁ to R₂₀ may be C1 to C3 substituted or unsubstituted alkyl which may be, for example, unsubstituted alkyl such as methyl, ethyl, propyl, n-butyl, isopropyl, isobutyl, or t-butyl or substituted alkyl such as trifluoromethyl, trifluoroethyl, difluoromethyl, or trichloromethyl;
(3) C1 to C5 substituted or unsubstituted alkylene mentioned in R₁ to R₂₀ may be C1 to C3 unsubstituted alkylene, such as methylene, ethylene, or propylene, or may be C1 to C3 substituted alkylene, such as halogen-substituted methylene or halogen-substituted ethylene, where halogen refers to fluorine, bromine, or chlorine.

The solubility of the polymer in the alkaline aqueous solution is derived from phenolic hydroxyl, and therefore, a certain proportion of phenolic hydroxyl is preferably included; more preferably, k = 2-10. Too large a value of k leads to a certain loss in a film thickness of an exposed area and a failure to effectively reproduce the pattern. An amount of grafted p-hydroxystyrene is adjusted so that the dissolution rate of the polymer in the alkaline aqueous solution changes and a photosensitive graft composition having a suitable dissolution rate can be obtained.

Further, in the polymer, m + n denotes the number of repeated structural units of the component (a), and a value of m + n is 5-200. When m + n is less than 5, the composition has too small a viscosity and cannot be used as a thick film. When m + n is greater than 200, the composition has too large a viscosity, affecting the coating.

When the structures represented by Formula 1 each include 10 or more wt% of fluorine, an interface of the film exhibits an appropriate degree of water repellency during development with the alkaline aqueous solution, preventing penetration at the interface. However, when the content of fluorine exceeds 20 wt%, the solubility in the alkaline aqueous solution is reduced. Therefore, the content of fluorine is preferably 10-20 wt%.

In terms of weight average molecular weight, the molecular weight of the component (a) is preferably 3000-200000 and more preferably 5000-100000. The molecular weight here is a value measured through gel permeation chromatography and converted from a standard polystyrene curve.

In the embodiment of the present application, the graft polymer having the structural unit represented by Formula 1 is generally obtained as follows: a dianhydride and a diamine are subjected to polycondensation to obtain a poly(amic acid) polymer, chemical imidization to obtain a polyimide polymer, chloromethylation and xanthate esterification to obtain a macromolecular initiator, and graft polymerization to obtain the polyimide-g-poly(p-hydroxystyrene) graft copolymer.

Specifically, in the first step, the diamine and the dianhydride are reacted to prepare poly(amic acid) and subjected to the chemical imidization to prepare polyimide; in the second step, polyimide is subjected to the chloromethylation and the xanthate esterification to obtain the macromolecular initiator; in the third step, the macromolecular initiator prepared in the second step is grafted to p-hydroxystyrene through reversible addition-fragmentation chain-transfer (RAFT) polymerization to prepare the graft polymer.

For the purpose of easily obtaining a cured film, the photosensitive polyimide composition according to the embodiment of the present application may include the thermal cross-linker as the component (b), where a component (b1) is a cross-linker having epoxy, and a component (b2) is a cross-linker having a -CH₂OR group (where R is hydrogen or a mono-substituted organic group). The component (b) is reacted and crosslinked with the polymer as the component (a) in a heating step after coating, exposure, and development of the photosensitive polymer composition of the present application, or the component (b) is polymerized itself to generate a compound in the heating step. Additionally, the cross-linker as the component (b2) has affinity for the alkaline aqueous solution and can increase the dissolution rate in the alkaline aqueous solution.

In the present application, the component (b1) is a cross-linker having an epoxy group in structure, and the component (b1) is selected from a compound represented by Formula 4-1:

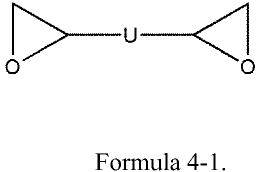

Examples of the compound represented by Formula 4-1 include Epiclon (registered trademark) 850-S, Epiclon HP-4032, Epiclon HP-7200, Epiclon HP-820, Epiclon HP-4700, Epiclon EXA-4710, Epiclon HP-4770, Epiclon EXA-859CRP, Epiclon EXA-4880, Epiclon EXA-4850, Epiclon EXA-4816, Epiclon EXA-4822 (where the above are trade names and manufactured by Dainippon Ink and Chemicals, Inc.), Rikaresin (registered trademark) BPO-20E, Rikaresin BEO-60E (where the above are trade names and manufactured by New Japan Chemical Co., Ltd.), EP-4003S, and EP-4000S (where the above are trade names and manufactured by ADEKA). The compounds may be used alone, or a mixture of two or more compounds may be used. Additionally, these compounds may be used alone, or a combination of two or more compounds may be used.

In the present application, the component (b2) is a cross-linker having a -CH₂OR group in structure (where R is hydrogen or a mono-substituted organic group). The compound may have one such group and preferably have two or more such groups. The component (b2) is selected from a compound represented by Formula 4-2-1 or Formula 4-2-2:

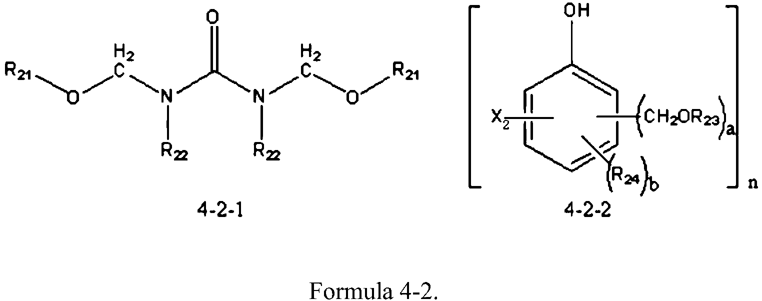

In Formula 4-2-1, R₂₁ is each independently hydrogen or a mono-substituted organic group, and R₂₂ is each independently hydrogen or a mono-substituted organic group and may be bonded to each other to form a ring structure that may have a substituent.

In Formula 4-2-2, R₂₃ is selected from hydrogen or a mono-substituted organic group, R₂₄ is selected from a mono-substituted organic group, n is an integer from 1 to 4, X is selected from mono-substituted to tetra-substituted organic groups, a is an integer from 1 to 4, and b is an integer from 0 to 3. When a is 2, 3, or 4, R₂₃ is the same or different, and when b is 2 or 3, R₂₄ is the same or different.

Examples of the compound represented by Formula 4-2-1 are represented by Formula 4-2-1-1, where these components may be used alone, or a combination of two or more compounds may be used: 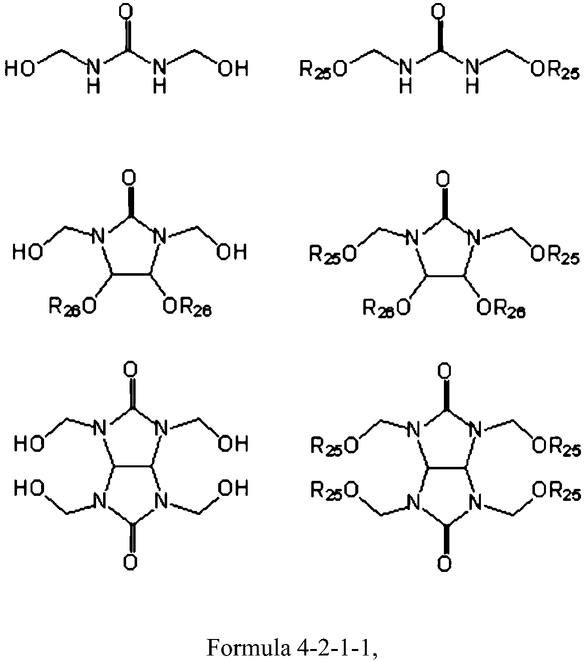 where R₂₅ is alkyl having 1 to 20 carbon atoms and preferably alkyl having 1 to 6 carbon atoms, and R₂₆ is alkyl having 1 to 10 carbon atoms.

Examples of the compound represented by Formula 4-2-2 are represented by Formula 4-2-2-1, where these components may be used alone, or a combination of two or more compounds may be used:

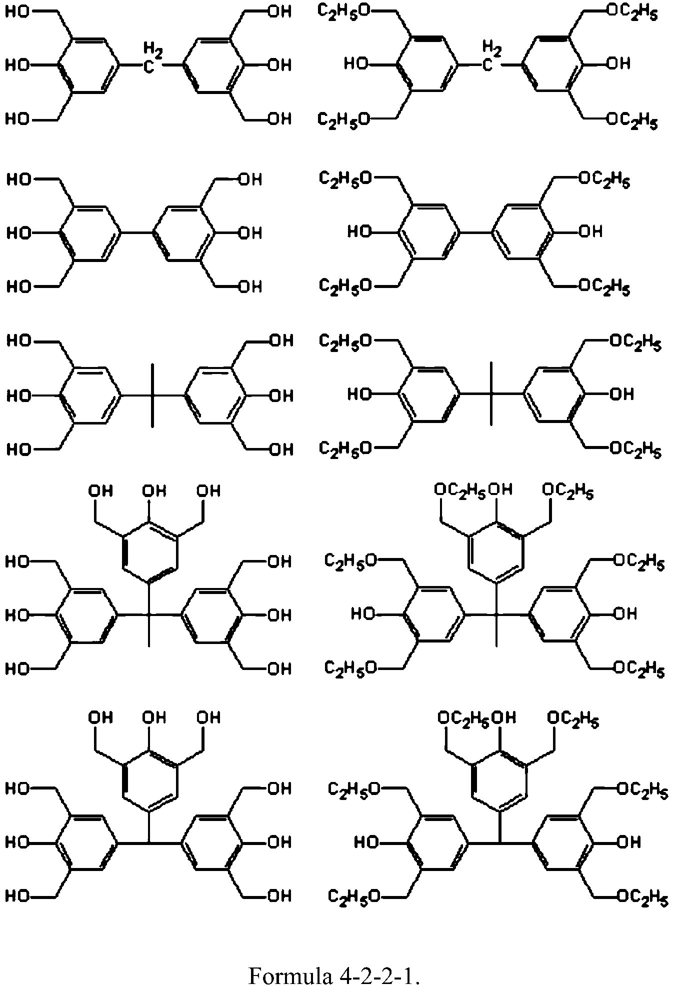

Additionally, in Formula 4-2-2, the mono-substituted to tetra-substituted organic groups of X may include alkyl having 1 to 10 carbon atoms, alkylene having 2 to 10 carbon atoms (such as ethylene), arylene having 6 to 30 carbon atoms (such as phenylene), or groups obtained by substituting part or all of hydrogen in hydroxyl groups with halogen such as fluorine, where these groups may further include phenyl, sulfonyl, carbonyl, an ether bond, a thioether bond, an amide bond, or the like. R₂₃ is preferably hydrogen, alkyl, or alkenyl. The number of carbon atoms in alkyl or alkenyl is preferably 1-20. R₂₄ is preferably alkyl, alkenyl, alkoxyalkyl, or hydroxymethyl in which the number of carbon atoms is preferably 1-20.

The purity of the compound represented by Formula 4-2 is preferably 75% or more and more preferably 85% or more. When the purity of the compound represented by Formula 4-2 is 85% or more, the compound has excellent storage stability and can undergo a thorough crosslinking reaction for the polyimide composition. Additionally, since unreacted groups that become water-absorbing groups can be reduced, the water absorption of the polyimide composition can be reduced. The thermal cross-linker with a high purity may be obtained by a method such as recrystallization or distillation. The purity of the thermal cross-linker may be determined through liquid chromatography.

Relative to 100 parts by mass of polyimide as the component (a), the content of the thermal cross-linker as the component (b) is preferably 5 or more parts by mass and more preferably 10 or more parts by mass. When the content of the thermal cross-linker is 5 or more parts by weight, the cured film has a higher crosslinking density, high chemical resistance, and low curing warpage. When the content of the thermal cross-linker is 10 or more parts by mass, the cured film has higher chemical resistance and lower curing warpage and can achieve higher mechanical performance. Additionally, considering the storage stability and mechanical strength of the composition, the content of the thermal cross-linker is preferably 30 parts by mass or less.

Further, the content of b1 is 5-15 parts by weight, for example, 5 parts, 6 parts, 7 parts, 8 parts, 9 parts, 10 parts, 11 parts, 12 parts, 13 parts, 14 parts, 15 parts, and any value between 5 parts and 15 parts; and the content of b2 is 0.1-15 parts, for example, 0.1 parts, 0.5 parts, 1 part, 2 parts, 5 parts, 7 parts, 8 parts, 10 parts, 13 parts, 14 parts, 15 parts, and any value between 0.1 parts and 15 parts.

In the present application, the photoacid generator as the component (c) refers to a compound that generates an acid through exposure to radiation or the like. Under the action of the acid, a functional group of the cross-linker is reacted with an alkali-soluble resin. The component (c) is selected from a compound represented by Formula 5: 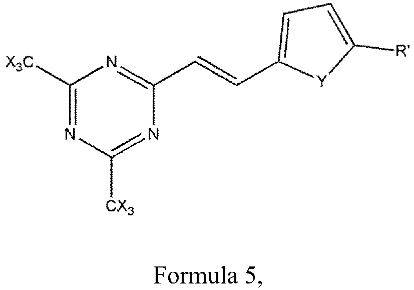 where R' represents hydrogen, alkyl having 1 to 4 carbon atoms, or alkoxy having 1 to 4 carbon atoms, X represents halogen, and Y represents oxygen or sulfur. The triazine derivative represented by Formula 5 has wide absorption in g-ray, h-ray, and i-ray areas and has higher acid generation efficiency and a higher residual film ratio than other general radiation-sensitive acid generators with triazine skeletons.

In Formula 5, R represents hydrogen, alkyl having 1 to 4 carbon atoms, or alkoxy having 1 to 4 carbon atoms, X represents halogen, and Y represents oxygen or sulfur. Examples of alkyl having 1 to 4 carbon atoms as R in Formula 5 include methyl, ethyl, n-propyl, isopropyl, n-butyl, isobutyl, sec-butyl, and t-butyl. Moreover, examples of alkoxy having 1 to 4 carbon atoms may include methoxy, ethoxy, propoxy, isopropoxy, n-butoxy, isobutoxy, and sec-butoxy. Additionally, R is preferably hydrogen or alkyl having 1 to 4 carbon atoms, such as hydrogen, methyl, or ethyl.

In Formula 5, X representing halogen is preferably fluorine, chlorine, bromine, or iodine and more preferably chlorine. The triazine derivative represented by Formula 5 includes 2-[2-(furan-2-yl)vinyl]-4,6-bis(trichloromethyl)-1,3,5-triazine or 2,4-bis(trichloromethyl)-6-(p-methoxystyryl)-S-triazine.

Relative to 100 parts by weight of polyimide as the component (a), the content of the photoacid generator as the component (c) is preferably 0.5-5 parts and more preferably 1-3 parts, for example, 1 part, 1.5 parts, 2 parts, 2.5 parts, 3 parts, and any value between 1 part and 3 parts. When the content of the photoacid generator is within the above range, higher sensitivity can be achieved.

The polyimide composition of the present application further includes the silane coupling agent as the component (d). The silane coupling agent is typically an organic silane compound, which may be, for example, γ-aminopropyltrimethoxysilane, γ-aminopropyltriethoxysilane, vinyltriethoxysilane, vinyltrimethoxysilane, γ-glycidyloxypropyltriethoxysilane, γ-glycidyloxypropyltrimethoxysilane, γ-methacryloxypropyltrimethoxysilane, γ-acryloxypropyltrimethoxysilane, γ-ureidopropyltriethoxysilane, 3-mercaptopropyltrimethoxysilane, 3-isocyanatopropyltriethoxysilane, bis(2-hydroxyethyl)-3-aminopropyltriethoxysilane, carbamatopropylethyltriethoxysilane, 3-(triethoxysilyl)propylsuccinic anhydride, phenyltriethoxysilane, phenyltrimethoxysilane, N-phenyl-3-aminopropyltrimethoxysilane, 3-triethoxysilyl-N-(1,3-dimethylbutylene)propylamine, or 2-(3,4-epoxycyclohexyl)ethyltrimethoxysilane.

When the polyimide composition includes the organic silane compound, the adhesiveness between the photosensitive polyimide composition and the substrate after curing can be improved. In the case where the organic silane compound is included, relative to 100 parts by mass of the component (a), the content of the organic silane compound is preferably 0.5-15 parts by mass and more preferably 0.5-10 parts by mass, for example, 0.5 parts, 1 part, 2 parts, 3 parts, 4 parts, 5 parts, 6 parts, 7 parts, 8 parts, 9 parts, 1 parts, 11 parts, 12 parts, 13 parts, 14 parts, 15 parts, and any value between 0.5 parts and 15 parts.

The polyimide composition of the present application further includes a solvent as a component (e). The solvent is preferably an organic solvent, which may be, for example, a ketone, an ester, a lactone, an ether, a halogenated hydrocarbon, or a hydrocarbon. Specific examples may include polar solvents such as γ-butyrolactone, N-methyl-2-pyrrolidone, N-acetyl-2-pyrrolidone, N,N-dimethylacetamide, N,N-dimethylsulfoxide, hexamethylphosphoramide, dimethyl imidazolidinone, tetraethylurea, tetramethylurea, ethyl lactate, 3-methoxy-N,N-dimethylpropionamide, and N-acetyl-ε-caprolactam. Other examples may include acetone, diethyl ketone, methyl ethyl ketone, methyl isobutyl ketone, cyclohexanone, methyl acetate, ethyl acetate, butyl acetate, diethyl oxalate, diethyl malonate, diethyl ether, ethylene glycol dimethyl ether, diethylene glycol dimethyl ether, tetrahydrofuran, dichloromethane, 1,2-dichloroethane, 1,4-dichlorobutane, trichloroethane, chlorobenzene, o-dichlorobenzene, hexane, heptane, octane, benzene, toluene, xylene, 1-methoxy-2-propanol, 1-methoxy-2-acetoxypropane, and propylene glycol 1-monomethyl ether 2-acetate. The component (e) may be any one or a combination of two or more of the above solvents.

In the case where the component (e) is included, relative to 100 parts by mass of the component (a), an amount of the component (e) is preferably 50-1000 parts by mass and more preferably 100-200 parts by mass, for example, 50 parts, 60 parts, 70 parts, 100 parts, 150 parts, 200 parts, 300 parts, 400 parts, 500 parts, 600 parts, 700 parts, 800 parts, 900 parts, and any value between 50 parts and 1000 parts.

The present application may further include a leveling agent as a component (f), where the leveling agent may be selected from a surfactant to improve coatability with the substrate. The surfactant may be, for example, a fluorine-based surfactant such as Fluorad (trade name, manufactured by Sumitomo 3M Limited), Megafac (trade name, manufactured by DIC Corporation), or Surflon (trade name, manufactured by AGC Inc.); an organic siloxane surfactant such as KP341 (trade name, manufactured by Shin-Etsu Chemical Co., Ltd.), DBE (trade name, manufactured by Chisso Corporation), Polyflow, Glanol (trade name, manufactured by Kyoeisha Chemical Co., Ltd.), or BYK (trade name, manufactured by BYK-Chemie GmbH); or an acrylic polymer surfactant such as Polyflow (trade name, manufactured by Kyoeisha Chemical Co., Ltd.).

Next, a method for manufacturing the photosensitive polyimide composition according to the embodiment of the present application is described. For example, the above components (a) to (d) and the components (e) and (f) used as required are uniformly mixed so that the photosensitive polyimide composition can be obtained. A dissolving method may include, for example, stirring and heating. During heating, the heating temperature is preferably set within a range that does not destroy the performance of the polyimide composition, and the range is generally room temperature-80°C. Additionally, the order in which the components are dissolved is not particularly limited, for example, the compounds are dissolved sequentially from a compound with a low solubility. Additionally, for components that easily generate bubbles during stirring and dissolving, such as the surfactant and some adhesion improvers, these components may be added at the end after other components have been dissolved, to prevent poor dissolution of the other components due to the generation of bubbles.

The obtained photosensitive polyimide composition is preferably filtered using a filter to remove impurities and particles. The pore size of the filter is 0.5-0.02 µm. For example, the pore size of the filter may be, but is not limited to, 0.5 µm, 0.2 µm, 0.1 µm, 0.05 µm, or 0.02 µm. A material of the filter includes polypropylene (PP), polyethylene (PE), nylon (NY), or polytetrafluoroethylene (PTFE), preferably polyethylene or nylon. When the photosensitive polyimide composition includes inorganic particles, a filter having a pore size larger than the particle diameter of the inorganic particles is preferably used.

A cured product according to an embodiment of the present application may be obtained by curing the above positive photosensitive polyimide composition. The cured product of the present application may be used as a patterned cured film or may be used as an unpatterned cured film.

A method for manufacturing the patterned cured film includes, for example, a step of coating the above positive photosensitive polyimide composition onto a substrate and drying them to form a photosensitive polyimide film (film forming step); a step of exposing the photosensitive polyimide film (exposure step); a step of developing the exposed photosensitive polyimide film with an alkaline aqueous solution to form a patterned polyimide film (development step); and a step of heating the patterned polyimide film (heating step). A method for manufacturing the unpatterned cured film includes, for example, the film forming step and the heating step and may further include the exposure step.

In the film forming step, for example, an immersion method, a spraying method, a screen printing method, a spin-coating method, or the like is used to coat the above positive photosensitive polyimide composition onto a support substrate such as a metal substrate (such as Cu), a glass substrate, a semiconductor, a metal oxide insulator (such as TiO₂ or SiO₂), or silicon nitride. Considering operability, the coated positive photosensitive polyimide composition may be dried for use by being heated with a hot plate, an oven, or the like (for example, at 90-150°C for 1-5 min); and the support substrate may be washed with acetic acid or the like before coating. The thickness of the obtained photosensitive polyimide film is preferably 5-20 µm.

In the exposure step, for example, active light is irradiated through a mask onto the photosensitive polyimide film formed on the substrate. Considering the transparency of the component (a), an i-ray may be properly used for irradiation.

In the development step, for example, an exposed portion of the photosensitive polyimide film after the exposure step is removed with a developer to pattern the photosensitive polyimide film. In the case where the photosensitive polyimide composition is alkali-soluble, the developer may be, for example, an alkaline aqueous solution of sodium hydroxide, potassium hydroxide, sodium silicate, ammonia, ethylamine, diethylamine, triethylamine, triethanolamine, or tetramethylammonium hydroxide (TMAH). The alkali concentration of the aqueous solution is preferably 0.1-10% by mass, and the developer may be added with an alcohol or a surfactant. Relative to 100 parts by mass of the developer, the alcohol or the surfactant may be preferably used in 0.01-10 parts by mass and more preferably 0.1-5 parts by mass. The patterned photosensitive polyimide film is referred to as the patterned polyimide film.

In the heating step, the patterned polyimide film or the photosensitive polyimide film is heated so that the photosensitive polyimide composition can be cured. In particular, a film obtained by curing the patterned polyimide film is referred to as the patterned cured film. The heating temperature is preferably 150-250°C, preferably less than or equal to 230°C, more preferably greater than or equal to 170°C, and further preferably 180-200°C. The heating time is preferably 20 min to 6 h and more preferably 30 min to 3 h. The heating step may be multi-stage heating. The heating may be performed using, for example, a quartz tube furnace, a hot plate, a rapid thermal anneal, a vertical diffusion furnace, an infrared curing oven, an electron beam curing oven, a microwave curing oven, or the like. Additionally, the heating may be performed in any one of the atmosphere or a non-reactive atmosphere such as nitrogen. Since the non-reactive atmosphere such as nitrogen can prevent the oxidation of the pattern, the non-reactive atmosphere such as nitrogen is preferably selected.

The cured product of the present application can be used as an interlayer insulating film, a surface protective film, or the like.

The interlayer insulating film and the surface protective film of the present application can be used for an electronic component or the like, and the electronic component of the present application can be used for a semiconductor device or the like. The semiconductor device can be used for various electronic apparatuses. A schematic diagram of a semiconductor packaging structure of the present application is shown in FIG. 1.

Thus, the film exhibits excellent anti-rust and adhesive effects on the support substrate (particularly, a copper substrate or a copper alloy substrate), and the discoloration of the cured film and the support substrate (particularly, the copper substrate or the copper alloy substrate) can be suppressed.

The semiconductor device may be, for example, a semiconductor package such as a wafer-level chip-scale package (WLCSP) or a fan-out wafer-level package (FOWLP). Additionally, the interlayer insulating film and the surface protective film of the present application may be used for a circuit-forming substrate, and the circuit-forming substrate can be used for a suspension for a hard disk drive, a flexible wiring board, or the like.

Features and performance of the present application are further described below in detail in conjunction with examples.
ODA: 4,4'-oxydianiline
SiDA: 1,3-bis(3-aminopropyl)tetramethyldisiloxane
ODPA: 4,4'-oxydiphthalic anhydride
Py: pyridine
Et₂A: acetic anhydride
PhA: phthalic anhydride
NMP: N-methyl-2-pyrrolidone
TMAH: tetramethylammonium hydroxide
CMM: chloromethyl methyl ether
SnCl₄: stannic chloride
AIBN: azobisisobutyronitrile
4-HS: p-hydroxystyrene
St: styrene
6FAP: 3,3-diamino-4,4-dihydroxybiphenyl-hexafluoropropane

### Synthesis Example 1

Under a dry nitrogen stream, 20.02 g (0.1 mol) of ODA was dissolved in 200 g of NMP, and the resulting solution was cooled to -10°C. Then, 26.37 g (0.085 mol) of ODPA was slowly added so that the temperature of the reaction solution was not higher than 0°C, the solution was stirred for 3 h, and 4.44 g (0.03 mol) of PhA was added and stirred for 2 h at room temperature to obtain a poly(amic acid) solution.

39.55 g of Py and 30.6 g of Et₂A were added to the poly(amic acid) solution, heated to 120°C, and reacted for 12 h. After the reaction was completed, the solution was poured into 2 L of deionized water, precipitated, washed with water, and vacuum-dried at 80°C to obtain a polyimide resin.

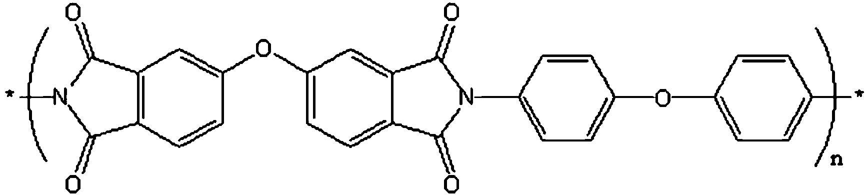

### Structure of the polyimide resin

The dried polyimide resin (5 g) was dissolved in 30 mL of dichloroethane, 80 µL of SnCl₄ was added and heated to 70°C, and 3 mL of CMM was slowly added dropwise to the system and stirred for 5 h. After the reaction was completed, the solution was poured into 300 mL of methanol, precipitated, washed, and dried at 80°C for 12 h to obtain a chloromethylated polyimide resin.

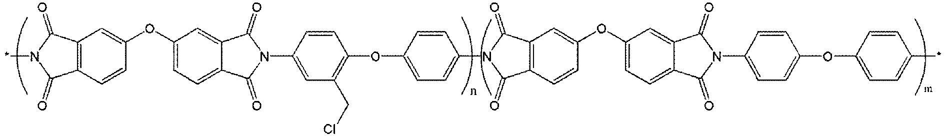

### Structure of the chloromethylated polyimide resin

The dried chloromethylated polyimide resin (1 g) was dissolved in 20 mL of NMP. After the dissolution was completed, 0.1 g of potassium ethyl xanthate was added and reacted at normal temperature for 24 h. After the reaction was completed, the solution was poured into 200 mL of deionized water, precipitated, and dried at 80°C for 12 h to obtain a macromolecular initiator.

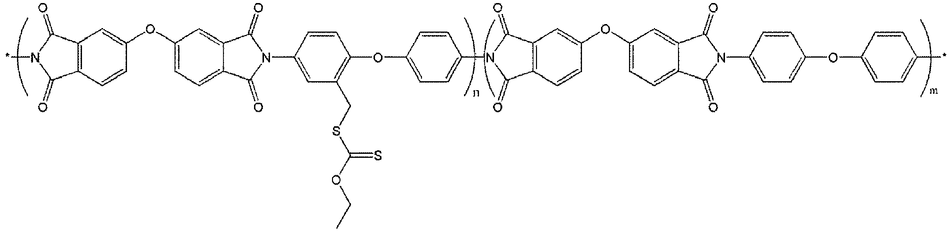

### Structure of the macromolecular initiator

The dried macromolecular initiator (1 g) was dissolved in 20 mL of NMP. After the dissolution was completed, the solution was heated to 65°C, 3 g of 4-HS was added dropwise, and 0.01 g of AIBN was added, subjected to RAFT polymerization, and reacted for 2 h. After the reaction was completed, the solution was cooled to room temperature, poured into 200 mL of deionized water, precipitated, washed with ethanol and water multiple times, and dried at 80°C for 12 h to obtain a polyimide-g-poly(p-hydroxystyrene) graft copolymer A1.

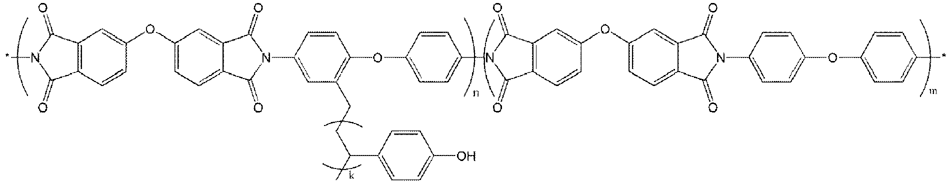

### Structure of the polyimide-g-poly(p-hydroxystyrene) graft copolymer

Test methods are described below.

### (1) Determination of molecular weight

The weight average molecular weight was determined through gel permeation chromatography (GPC) and standard polystyrene conversion under the conditions below. Polymer A has a weight average molecular weight of 39000. Relative to 0.5 mg of A, 1 mL of a solution of solvents [tetrahydrofuran (THF)/dimethylformamide (DMF) = 1:1 (volume ratio)] was used.

### Determination device: Detector L4000UV manufactured by Hitachi, Ltd.

Pump L6000 manufactured by Hitachi, Ltd.
C-R4A Chromatopac manufactured by Shimadzu Corporation

### Determination conditions: Two chromatographic columns Gelpack GL-S300MDT-5

Eluent: THF/DMF = 1/1 (volume ratio), LiBr (0.03 mol/L), H₃PO₄ (0.06 mol/L)
Flow rate: 1.0 mL/min Detector: UV 270 nm

### (2) Determination of grafting ratio n/(m + n)

NMR determination was performed under the conditions below. The grafting ratio of A1 was calculated to be 40%.
Determination apparatus: AV400M manufactured by Bruker BioSpin Group
Magnetic field intensity: 400 MHz
Reference substance: Tetramethylsilane (TMS)
Solvent: Dimethylsulfoxide (DMSO)

### (3) Determination of graft k

NMR determination was performed under the conditions below. The graft k of A1 was calculated to be 3.5.
Determination apparatus: AV400M manufactured by Bruker BioSpin Group
Magnetic field intensity: 400 MHz
Reference substance: Tetramethylsilane (TMS)
Solvent: Dimethylsulfoxide (DMSO)

### Synthesis Example 2

192 g of methanol, 172.32 g of 4-HS, 19.53 g of St, and 15 g of AIBN were sequentially added to a four-necked flask, stirred, and dissolved until the solution was clear. The reaction vessel was vacuumed and purged with nitrogen to replace the air therein, the solution was heated to 75°C and reacted for 18 h, and the reaction was stopped. A prepared solution of sodium (0.4 g) in methanol was slowly added to the reaction system, reacted for 6 h, and extracted twice or three times with heptane whose mass ratio to the reaction solution was 1:1. The unreacted monomer and initiator were removed from the reaction solution, and methanol in the reaction solution was replaced with PGMEA to obtain a PGMEA solution with a desired concentration. A PHS resin A2 was obtained, where the ratio of repeated units of p-hydroxystyrene and styrene was 80:20.

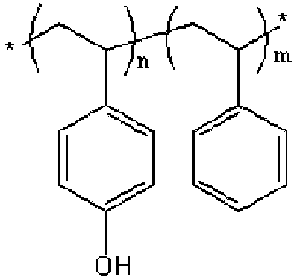

### Structure of the PHS resin A8

### Synthesis Example 3

Under a dry nitrogen stream, 36.63 g (0.1 mol) of 6FAP was dissolved in 200 g of NMP, and the resulting solution was cooled to -10°C. Then, 26.37 g (0.085 mol) of ODPA was slowly added so that the temperature of the reaction solution was not higher than 0°C, the solution was stirred for 3 h, and 4.44 g (0.03 mol) of PhA was added and stirred for 2 h at room temperature to obtain a poly(amic acid) solution.

39.55 g of Py and 30.6 g of Et₂A were added to the poly(amic acid) solution, heated to 120°C, and reacted for 12 h. After the reaction was completed, the solution was poured into 2 L of deionized water, precipitated, washed with water, and vacuum-dried at 80°C to obtain a polyimide resin A3.

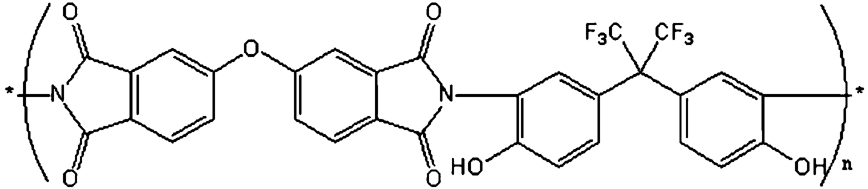

### Structure of the polyimide resin A9

### Examples 1 to 10 and Comparative Examples 1 and 2

The photosensitive polyimide compositions in Examples 1 to 5 and Comparative Example 1 were prepared according to the components and their amounts shown in Tables 1 and 2. The amounts in Table 1 are parts by mass of the components relative to 100 parts by mass of the component (a).

The used components are described as follows:
component (b): thermal cross-linker 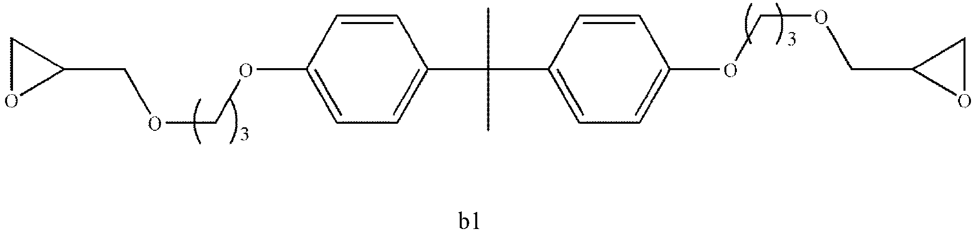 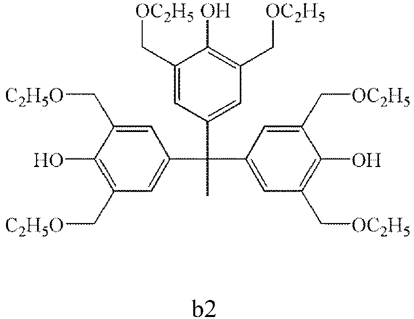
component (c): photosensitizer 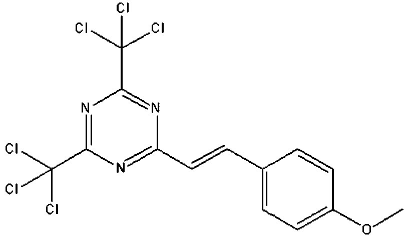
component (d): silane coupling agent: γ-ureidopropyltriethoxysilane
component (e): solvent
e1: GBL (γ-butyrolactone)
e2: EL (ethyl lactate)

**Table 1**

| | | Example 1 | Example 2 | Example 3 | Example 4 | Example 5 | Example 6 |
|---|---|---|---|---|---|---|---|
| Component (a) | Polymer A1 | 100 | 100 | 100 | 100 | 100 | 100 |
| | Polymer A2 | - | - | - | - | | |
| | Polymer A3 | | | | | | |
| Component (b) | b1 | 10 | 15 | 10 | 5 | 0 | 5 |
| | b2 | 5 | 10 | 10 | 10 | 15 | 10 |
| Component (c) | | 2 | 2 | 2 | 2 | 2 | 1.5 |
| Component (d) | | 2 | 2 | 2 | 2 | 2 | 2 |
| Component (e) | e1 | 144 | 144 | 144 | 144 | 144 | 144 |
| | e2 | 36 | 36 | 36 | 36 | 36 | 36 |

**Table 2**

| | | Example 7 | Example 8 | Example 9 | Example 10 | Comparative Example 1 | Comparative Example 2 |
|---|---|---|---|---|---|---|---|
| Component (a) | Polymer A1 | 100 | 100 | 100 | 100 | | |
| | Polymer A2 | - | - | - | - | 100 | |
| | Polymer A3 | | | | | | 100 |
| Component (b) | b1 | 5 | 5 | 5 | 5 | 5 | 5 |
| | b2 | 10 | 10 | 10 | 10 | 10 | 10 |
| Component (c) | | 2.5 | 3 | 3.5 | 4 | 2 | 2 |
| Component (d) | | 2 | 2 | 2 | 2 | 2 | 2 |
| Component (e) | e1 | 144 | 144 | 144 | 144 | 144 | 144 |
| | e2 | 36 | 36 | 36 | 36 | 36 | 36 |

The performance of the photosensitive polyimide compositions prepared in the examples and comparative examples was evaluated by the methods below.

### (1) Preparation of developed film

The photosensitive polyimide compositions (varnishes) prepared in the examples and comparative examples were each spin-coated onto an 8-inch silicon wafer and heated (prebaked) at 120°C for 3 min with a hot plate (coating and development device Mark-7 manufactured by Tokyo Electron Ltd.) to prepare a prebaked film 6 µm thick. The obtained prebaked film was exposed with an i-line stepper (NSR-2005i9C manufactured by Nikon Corporation) under an exposure dose of 50-400 mJ/cm² and a step of 10 mJ/cm². After the exposure, the photosensitive polyimide composition was exposed at 100°C for 1 min and baked. After being exposed and baked, the photosensitive polyimide composition was developed for 90s with a 2.38 wt% aqueous solution of tetramethylammonium (TMAH) (ELM-D manufactured by Mitsubishi Gas Chemical Company, Inc.) and rinsed with pure water to obtain the developed film.

### (2) Determination method for film thickness

The film thickness after prebaking and the film thickness after development were determined at a refractive index of 1.63 with a film thickness determination device Filmtris F50.

### (3) Determination of warpage

A varnish was coated by a spin-coating method and prebaked at 120°C for 3 min with a coating and development device ACT-8 so that the film thickness after prebaking was 10 µm. Then, the film was heated to 200°C at a rate of 3.5°C/min in an inert oven with an oxygen concentration of 20 ppm or lower and heated at 200°C for 1 h. When the temperature changed to 50°C or lower, the wafer was taken out, and the cured film was determined with a pressure device FLX2908 (manufactured by KLA Tencor). A result higher than or equal to 35 MPa was regarded as insufficient (D), a result higher than or equal to 30 MPa and lower than 35 MPa was regarded as good (C), a result higher than or equal to 20 MPa and lower than 30 MPa was regarded as better (B), and a result lower than 20 MPa was regarded as best (A).

### (4) Evaluation of alkali solubility-minimum development time

The photosensitive compositions (varnishes) prepared in the examples and comparative examples were each spin-coated onto an 8-inch silicon wafer and heated (prebaked) at 120°C for 3 min with a hot plate (coating and development device Mark-7 manufactured by Tokyo Electron Ltd.) to prepare a prebaked film 10 µm thick. The film was developed with a 2.38 wt% aqueous solution of tetramethylammonium (TMAH). The minimum development time was recorded after the film was completely dissolved. The results are shown in Table 3.

### (5) Evaluation of chemical resistance

The preceding cured product was coated with a pipette. The coated cured product was placed in a nitrogen oven of 200°C and held for 60 min. Then, the cured product was transferred from a heating plate and cooled to room temperature. The cooled cured product was washed and soaked for 1 h with NMP at 45°C, and the film thickness was determined.

A change rate (%) of the film thickness was calculated according to changes in the film thickness. If the change rate had a positive value, it indicated that the film was swollen. If the change rate had a negative value, it indicated that the film was dissolved. The results are shown in Table 3.

### (6) Evaluation of adhesiveness

The cured product was manufactured on a Cu substrate by the preceding method for manufacturing the cured product, and the obtained cured product was divided into 100 pieces by cutting a 10×10 checkerboard grid with a cutting blade and a crosscut guide (manufactured by Coat Tech LLC).

An adhesive tape (manufactured by 3M Japan Co., Ltd.) was attached to the cured product and peeled off. The adhesiveness was evaluated as follows according to the number of pieces of the cured product that were peeled off from the substrate when the adhesive tape was peeled off:
A: 100-80 squares were remaining;
B: less than 80 squares were remaining.

The results are shown in Table 3.

### (7) Evaluation of elongation at break

The varnish was coated by the spin-coating method and prebaked at 120°C for 3 min with the coating and development device ACT-8 so that the film thickness after prebaking was 10 µm. Then, the film was heated to 200°C at a rate of 3.5°C/min in an inert oven with an oxygen concentration of 20 ppm or lower and heated at 200°C for 1 h. When the temperature changed to 50°C or lower, the wafer was taken out, the film was peeled off and cut into sample strips of 4 mm × 8 mm, and a tensile test was performed with DAGE4000.

As for the results, an elongation at break greater than 30% was regarded as excellent (A), an elongation at break of 20% to 30% was regarded as good (B), an elongation at break of 10% to 20% was regarded as fair (C), and an elongation at break less than 10% was regarded as poor (D).

**Table 3**

| | Elongation at Break | Warpage Stress | Minimum Development Time | Chemical Resistance | Adhesiveness |
|---|---|---|---|---|---|
| Example 1 | A | A | 50s | No change | A |
| Example 2 | A | A | 47s | No change | A |
| Example 3 | A | A | 49s | No change | A |
| Example 4 | A | A | 45s | No change | A |
| Example 5 | A | A | 42s | No change | A |
| Example 6 | A | A | 45s | No change | A |
| Example 7 | A | A | 44s | No change | A |
| Example 8 | A | A | 44s | No change | A |
| Example 9 | A | A | 45s | No change | A |
| Example 10 | A | A | 44s | No change | A |
| Comparative | D | B | 150s | 5% | A |
| Example 1 | | | | swelling | |
| Comparative Example 2 | A | C | 200s | 20% reduction | C |

As can be seen from Table 3, the photosensitive polyimide compositions in Examples 1 to 10 of the present application all have relatively strong alkali solubility, quite low warpage stress, and excellent chemical resistance. Compared with the examples, Comparative Example 1 has relatively poor toughness and relatively poor alkali solubility, and Comparative Example 2 has high warpage stress, relatively poor alkali solubility, relatively poor bonding to the substrate, and relatively poor chemical resistance.

The preceding description of example embodiments of the present application is provided for the purposes of explanation and illustration. The description is not intended to limit the present application to the precise forms disclosed, and apparently, many changes and variations can be made in light of the above teachings. The example embodiments are selected and described for the purpose of explaining particular principles and practical applications of the present application so that those skilled in the art can implement and utilize various different example embodiments of the present application and various different selections and changes. The scope of the present application is subject to the claims and equivalents thereof.

## Claims

1. A photosensitive polyimide composition, comprising the following raw materials in parts by weight:
100 parts of a block polymer, which is soluble in an alkaline aqueous solution and has a structural formula of 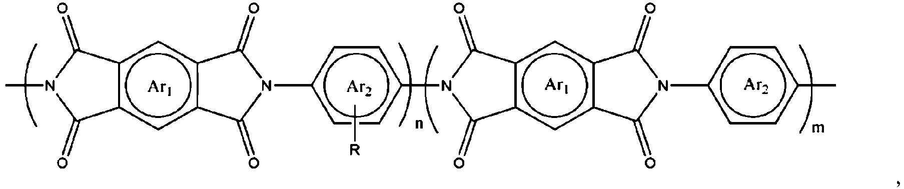
wherein R is 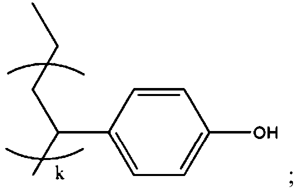 Ar₁ is selected from a tetra-substituted organic group and Ar₂ is selected from a di-substituted organic group; m + n = 5-200, n/(m + n) = 0.05-1, and k = 2-10;
5-30 parts of a thermal cross-linker, which is selected from an epoxy-containing cross-linker or a -CH₂OR-containing cross-linker;
0.5-5 parts of a photoacid generator, which has a structural formula of 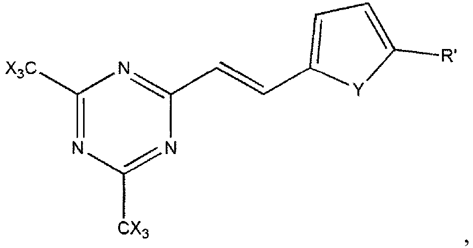 wherein R' is selected from hydrogen, alkyl having 1 to 4 carbon atoms, or alkoxy having 1 to 4 carbon atoms, X is selected from halogen, and Y is oxygen or sulfur; and
0.5-10 parts of a silane coupling agent.

2. The photosensitive polyimide composition according to claim 1, wherein Ar₁ is the tetra-substituted organic group selected from the following: 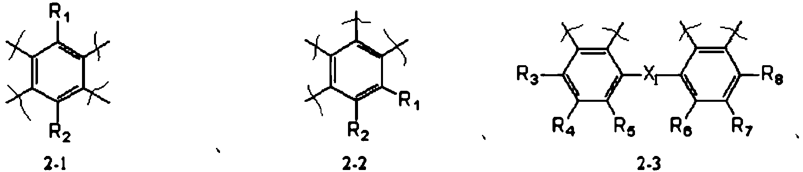 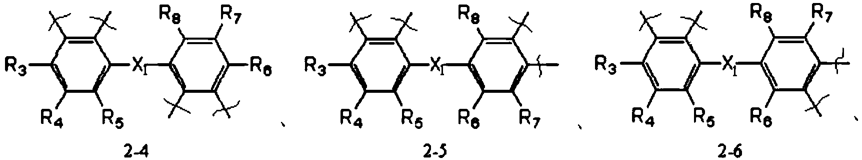 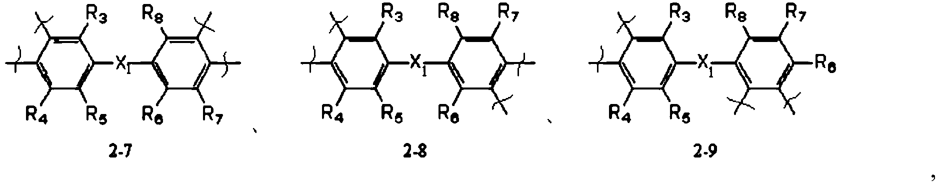 wherein R₁ to R₈ are mono-substituted organic groups, and X₁ is a di-substituted group.

3. The photosensitive polyimide composition according to claim 2, wherein R₁ to R₈ are the mono-substituted organic groups each independently selected from any one of hydrogen, halogen, C1 to C5 substituted alkyl, or C1 to C5 unsubstituted alkyl.

4. The photosensitive polyimide composition according to claim 3, wherein R₁ to R₈ are the mono-substituted organic groups each selected from any one of hydrogen, fluorine, methyl, or trifluoromethyl.

5. The photosensitive polyimide composition according to claim 2, wherein X₁ is the di-substituted group selected from any one of oxygen, C1 to C5 substituted or unsubstituted alkylene, sulfur, sulfonyl, or carbonyl.

6. The photosensitive polyimide composition according to claim 5, wherein X₁ is the di-substituted group selected from any one of oxygen, methylene, sulfur, sulfonyl, carbonyl, -C(CH₃)₂-, or -C(CF₃)₂-.

7. The photosensitive polyimide composition according to claim 1, wherein Ar₂ is the di-substituted organic group selected from the following: 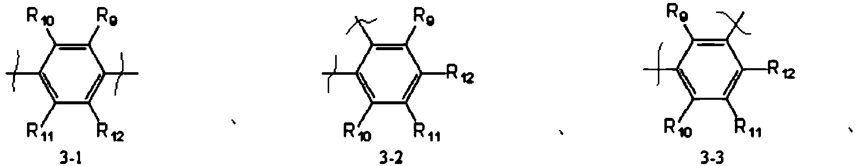 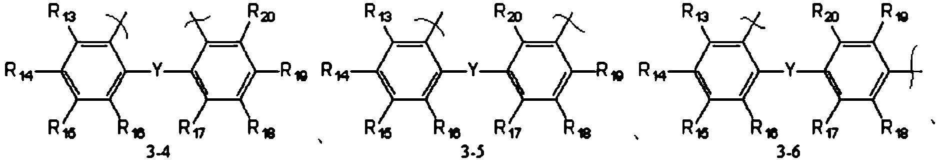 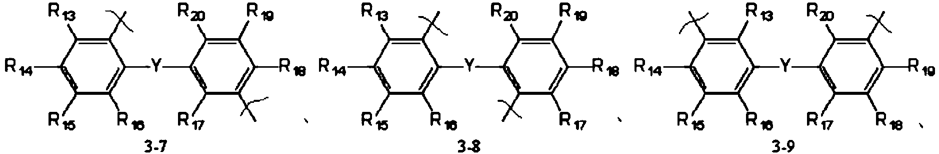 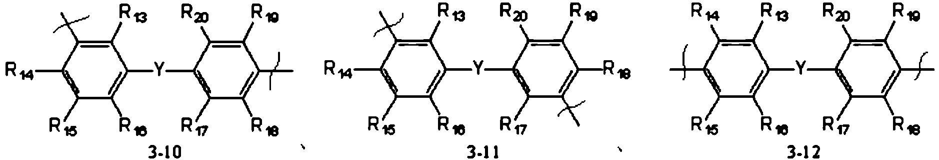 wherein R₉ to R₂₀ are mono-substituted organic groups, and Y is a di-substituted group.

8. The photosensitive polyimide composition according to claim 7, wherein R₉ to R₂₀ are the mono-substituted groups each independently selected from any one of hydrogen, halogen, C1 to C5 substituted alkyl, or C1 to C5 unsubstituted alkyl.

9. The photosensitive polyimide composition according to claim 8, wherein R₉ to R₂₀ are the mono-substituted groups each independently selected from any one of hydrogen, fluorine, methyl, or trifluoromethyl.

10. The photosensitive polyimide composition according to claim 7, wherein Y is the di-substituted group selected from any one of oxygen, C1 to C5 substituted alkylene, C1 to C5 unsubstituted alkylene, sulfur, sulfonyl, or carbonyl.

11. The photosensitive polyimide composition according to claim 10, wherein Y is the di-substituted group selected from any one of oxygen, methylene, sulfur, sulfonyl, carbonyl, -C(CH₃)₂-, or -C(CF₃)₂-.

12. The photosensitive polyimide composition according to claim 1, wherein the thermal cross-linker is selected from a compound represented by any one of the following formulas: 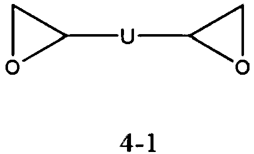 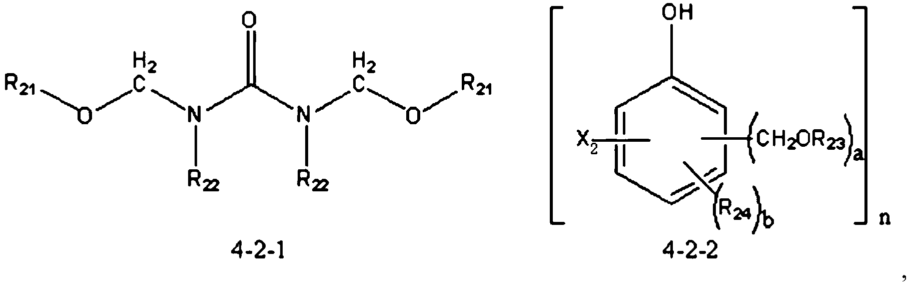 wherein U is selected from a di-substituted organic group containing an alicyclic ring or an aromatic ring, R₂₁ is independently selected from hydrogen or a mono-substituted organic group, R₂₂ is selected from hydrogen, a mono-substituted organic group, or a ring structure having a substituent, R₂₃ is selected from hydrogen or a mono-substituted organic group, R₂₄ is selected from a mono-substituted organic group, n is an integer from 1 to 4, X₂ is selected from a mono-substituted organic group, a di-substituted organic group, a tri-substituted organic group, or a tetra-substituted organic group, a is an integer from 1 to 4, and b is an integer from 0 to 3.

13. The photosensitive polyimide composition according to any one of claims 1 to 12, further comprising 100-200 parts of a solvent and/or 100-1000 ppm of a leveling agent.

14. A method for manufacturing a pattern, comprising coating the photosensitive polyimide composition according to any one of claims 1 to 13 on a support substrate, followed by drying, exposure, development, and heating.

15. The method for manufacturing a pattern according to claim 14, wherein a light source for the exposure is an i-ray.

16. A photocured structure obtained by the method for manufacturing a pattern according to claim 14 or 15.

17. An electronic component, comprising a body and the photocured structure according to claim 16, the photocured structure being formed on the body.

18. An apparatus, comprising a body and the electronic component according to claim 17, the electronic component being disposed to the body.
